# EUROPÄISCHE PATENTANMELDUNG

(11) **EP 2 050 687 A1**
(43) Veröffentlichungstag der Anmeldung: **22.04.2009**
(21) Anmeldenummer: 08018319.7
(22) Anmeldetag: 20.10.2008
(51) Int. Cl.: B65D 65/14, B32B 29/06, H05K 9/00, D21H 27/10, D21H 21/14, D21H 19/36

(54) **Ein- oder mehrschichtige Materialbahn**

(30) Priorität: 18.10.2007 DE 202007014725 U
(71) Anmelder: HANS KOLB Wellpappe GmbH & Co. KG, 87855 Memmingen (DE)
(72) Erfinder: Paul, Jürgen, 87730 Bad Grönenbach (DE)
(74) Vertreter: Fiener, Josef

(57) **Zusammenfassung**

Für eine kostengünstige Verpackung mit Schutz vor elektrischen Auf- bzw. Entladungen wird eine ein- oder mehrschichtige Materialbahn (10), insbesondere aus Zell- oder Faserstoff vorgeschlagen, wobei an wenigstens einer Oberfläche (13a, b) der Materialbahn (10) eine drucksensitive und/oder hitzeaktivierbare Klebe- und/oder Siegelschicht (14) vorgesehen ist, die leitfähig ausgebildet ist, insbesondere eine antistatische Beimischung oder leitfähige Pigmente aufweist. Zudem wird eine entsprechende Verpackung aus einer solchen ein- oder mehrschichtigen Materialbahn (10), insbesondere für einen gegenüber elektrischen Auf- oder Entladungen anfälligen Gegenstand (20), vorgeschlagen, wobei die Umhüllung durch Aufeinanderlegen von mit der drucksensitiven und/oder hitzeaktivierbaren Klebe- und/oder Siegelschicht (14) versehenen Oberflächen (13a, b) und/oder Oberflächenabschnitten der Materialbahn (10) gebildet ist.

## Beschreibung

Die Erfindung betrifft eine ein- oder mehrschichtige Materialbahn mit den oberbegrifflichen Merkmalen des Anspruchs 1 und eine daraus gebildete Verpackung mit den oberbegrifflichen Merkmalen des Anspruchs 10.

Bei der Verpackung von Gegenständen, die besonders anfällig auf elektrische Entladungen bzw. Aufladungen reagieren, werden in der Regel Kunststoffverpackungen verwendet, die eine spezielle sog. Shielding-Funktion mit hohem elektrischem Oberflächenwiderstand aufweisen. Nachteilig an solchen Kunststoffverpackungen ist es, dass die Beschichtungen oft nicht dauerhaft an den Kunststoffoberflächen verbleiben, sodass die Verpackungen mit dem Verlust auch ihre antistatische Wirkung verlieren und daher den verpackten Gegenstand nicht mehr schützen können. Zudem bieten die Kunststoffverpackungen oftmals keinen Schutz gegen eine mechanische Beschädigung der verpackten Gegenstände.

Die DE 692 12 5212 T2 schlägt einen Behälter aus Karton, Pappe oder Papier vor, in dem Komponenten, die empfindlich gegen elektrostatische Beschädigung sind, verpackt werden können. Der Behälter weist dabei sowohl auf der Innen- wie auch der Außenseite eine elektrisch leitfähige Beschichtung auf. Nachteilig am vorgeschlagenen Behälter ist, dass vor dem Verpacken zunächst ein Zusammenbau des Behälters in einem gesonderten Arbeitsgang erfolgen muss. Zum Verpacken von Gegenständen mit unterschiedlicher Größe müssen verschiedene Behältergrößen vorgehalten werden. Die Oberflächenbeschaffenheit kann auch im Fall der gezeigten Verpackung nach längeren Einsatzzeiten vom Trägermaterial abgerieben werden und somit eine elektrostatische Beschädigung der verpackten Gegenstände auftreten.

Bei Bildung einer Verpackung aus Wellpappe bietet das verwendete Material zwar einen guten Schutz gegen mechanische Beschädigung, jedoch nur unzureichenden Schutz gegen eine elektrostatische Beschädigung der verpackten Gegenstände bietet.

Aufgabe der vorliegenden Erfindung ist es daher, eine Materialbahn sowie eine daraus gefertigte Verpackung zur Verfügung zu stellen, wobei die Materialbahn ebenso wie die Verpackung einfach und kostengünstig herstellbar sind und einen dauerhaften Schutz gegen elektrische Entladungen bieten.

Diese Aufgabe wird gelöst durch eine Materialbahn gemäß Anspruch 1 sowie durch eine aus der erfindungsgemäßen Materialbahn hergestellte Verpackung gemäß Anspruch 10. Vorteilhafte Weiterbildungen der Erfindung sind Gegenstand der abhängigen Ansprüche.

Die erfindungsgemäße Materialbahn weist einen ein- oder mehrschichtigen Aufbau auf und verfügt an wenigstens einer Oberfläche über eine drucksensitive und/oder hitzeaktivierbare Klebe- und/oder Siegelschicht. Die drucksensitive Klebeschicht kann dabei beispielsweise aus mikroverkapselten Klebstoffen gebildet werden, die ihre Klebewirkung erst nach einer definierten Druckbeaufschlagung entwickeln. Die Materialbahn besteht insbesondere aus Zell- oder Faserstoffen, wie beispielsweise aus Frischzellulose, aus recyceltem Altpapier oder aus Mischungen dieser Stoffe. Darüber hinaus können auch aus synthetischen oder halbsynthetischen Polymerfasern oder weiteren Naturfasern bestehende Materialbahnen verwendet werden.

Bei einer mehrschichtigen Materialbahn können die einzelnen Schichten auch aus verschiedenen Materialien bestehen. Die Materialbahn, die sich auch zur Bildung eines Verpackungsmaterials aus Wellpappe eignet, ist **dadurch gekennzeichnet, dass** die drucksensitive und/oder hitzeaktivierbare Klebe- und/oder Siegelschicht leitfähig oder antistatisch ausgebildet ist, insbesondere mittels einer antistatischen Beimischung, wobei bevorzugt dem Schichtmaterial u.a. leitfähige Pigmente beigegeben werden.

Bevorzugt weist die Klebe- und/oder Siegeischicht dabei einen elektrischen Oberflächenwiderstand zwischen 10² und 10¹⁴ Ohm, insbesondere zwischen 10⁵ und 10¹² Ohm, bevorzugt zwischen 10⁸ und 10¹¹ Ohm auf.

Als besonders vorteilhaft wird angesehen, wenn die Beimischung aus einem Partikelmaterial gebildet ist. Als Beimischung in Form eines kohlenstoffhaltigen Materials eignet sich vor allem Partikelmaterial aus Kohlenstoffruß oder Graphit sowie eine Mischung daraus. Kohlenstofffreies Partikelmaterial kann beispielsweise leitfähige Metallbestandtelle wie beispielsweise Aluminium, Nickel, Kadmium, Zinn, Chrom, Blei, Kupfer, Zink oder Kombinationen bzw. Mischformen daraus beinhalten oder aus Partikeln amorphen Siliziumdioxids oder Siliziumdioxid enthaltenden Materials bestehen, wobei die Partikel z. B. mit Zinnoxid und Antimon beschichtet sind.

Bevorzugt weist die Materialbahn wenigstens eine gewellte Materialschicht auf, die mit wenigstens einer ebenen Materialschicht verbunden ist. Durch diese Ausgestaltung der Materialbahn kann ein flexibles, leicht umschlagbares Material zur Verfügung gestellt werden, dass dennoch stabil genug ist, um Gegenstände gegen mechanische Beschädigung zu schützen. In der Herstellung weist eine zwei- oder mehrschichtige Materialbahn mit einer gewellten Materialschicht dabei an beiden Oberflächen drucksensitive Klebeschichten auf. Anstelle der drucksensitiven Klebeschichten oder aber ergänzend zu diesen, können hitzeaktivierbare Siegelschichten auf den inneren Oberflächen der Materialbahn vorgesehen werden. Darüber hinaus sind auch Kombinationen aus Siegel- und Klebeschichten auf verschiedenen Oberflächen denkbar. Die drucksensitive Klebeschicht an der freien Oberfläche, die erst nach Fertigstellung der ein- oder mehrschichtigen Materialbahn aufgetragen werden kann, kann dabei beispielsweise aus mikroverkapselten Klebstoffen mit entsprechenden antistatische Beimischungen gebildet werden, und entwickelt ihre Klebewirkung erst nach einer definierten Druckbeaufschlagung. Die innere Oberflächen der Materialbahn, die zunächst zusammengeführt werden, können hitzeaktivierbare Siegelschichten aufweisen und nach Temperaturbeaufschlagung zur fertigen Materialbahn verkleben.

Als Siegelschicht können u.a. Wachse oder geeignete Schmelzkunststoffe verwendet werden, die auch in der Lage sind, in das Zellstoff- oder Fasermaterial einzudringen, um dort einen Imprägniereffekt zu entwickeln. Sind die Komponenten der Siegelschicht entsprechend antistatisch aktiviert, erfolgt durch das Eindringen des geschmolzenen Materials eine zusätzliche Erhöhung des elektrischen Oberflächenwiderstandes der Materialbahn.

Eine weitere vorteilhafte Ausführungsform der erfindungsgemäßen Materialbahn sieht vor, dass die Klebe- und/oder Siegelschicht in die jeweilige Materialschicht bzw. die Materialschichten eingearbeitet ist. Mit einer derartigen Ausführung können die Materialschichten bei der Herstellung der Materialbahn getrennt voneinander gelagert und/oder angeliefert werden. Die gewünschte Klebewirkung entfalten die Materialschichten erst während oder nach dem Verbinden durch Druck- und/oder Wärmebeaufschlagung.

Als besonders günstig wird angesehen, wenn die Klebe- und/oder Siegelschicht punkt- und/oder bahnförmig auf der Materialschicht aufgebracht ist. Durch die punktuelle bzw. streifenweise Auftragung der Adhäsionsschicht können die Materialschichten beispielsweise nur an den Stellen mit Klebstoff versehen werden, aus denen anschließend Zuschnitte o.ä. aus der Materialbahn ausgestanzt werden sollen, Zum einen sinkt dadurch der Klebstoffverbrauch, zum anderen können die ungenutzten und kleberfreien Materialbahnreste einfacher und wesentlich umweltfreundlicher recycelt werden.

Um gegen Beschädigung und/oder Verschmutzung geschützt zu sein, ist die Klebeschicht in vorteilhafter Weise mit einer abziehbaren Schutzschicht belegt. Die Schutzschicht, die beispielsweise aus einer dünnen, antihaftbeschichteten Papier- oder Folienbahn gebildet sein kann, wird abgezogen, bevor die Materialschichten verbunden werden.

Um die aus der Materialbahn hergestellten Produkte auch bei hoher Luftfeuchte verwenden zu können und um eine Zersetzung der Materialschichten durch eindringende Feuchtigkeit zu vermeiden, wird es als besonders empfehlenswert angesehen, wenn die Klebe- und/oder Siegelschicht wasserabweisende Eigenschaften aufweist. Mit dem Auftragen einer entsprechend aktivierten Klebeschicht wird dabei gleichzeitig eine Beschichtung der Materialbahn durchgeführt. Bei Verwendung einer hitzeaktivierten Klebe- oder Siegelschicht, beispielsweise auf Wachsbasis, kann durch Einziehen der die Klebe- oder Siegelschicht bildenden Substanzen eine durchgehende Imprägnierung der Materialbahn oder der die Materialbahn bildenden Materialschichten erreicht werden, womit ein noch besserer Schutz der fertigen Materialbahn bzw. der daraus hergestellten Produkte erreicht wird.

Bevorzugt ist die Klebe- und/oder Siegelschicht staubbindend ausgebildet. So kann gewährleistet werden, dass bei der Herstellung der Materialbahn oder beim Abtrennen von Abschnitten entstehender Staub nicht in die Umgebungsluft gelangt. Dadurch wird die durch eingeatmete Papierstäube bedingte Gesundheitsbelastung bei Arbeiten im direkten Umfeld der Materialbahn und/oder der Zuschnittstationen erheblich reduziert und eine Verunreinigung von verpackten Waren durch in den Verpackungen oder auf der Materialbahn vorhandenen Papierstaub unterbunden.

Eine weitere Ausführungsform der Erfindung sieht vor, dass aus der erfindungsgemäßen Materialbahn eine Verpackung hergestellt wird, die sich insbesondere zum Verpacken von gegen elektrische Entladungen anfällige Gegenstände (z. B. Transistoren) eignet und
dadurch gekennzeichnet ist, dass die Verpackung nach Art einer Umhüllung, insbesondere in Taschen- oder Umschlagform, ausgebildet ist. Zur Bildung der Verpackung werden mit der drucksensitiven und/oder hitzeaktivierbaren Klebe- und/oder Siegelschicht versehene Oberflächen und/oder Oberflächenabschnitten der Materialbahn gefaltet bzw. aufeinandergelegt und die aufeinanderliegenden Oberflächen an den Rändern bzw. im Bereich um den verpackten Gegenstand, druck- bzw. hitzebeaufschlagt. Aufgrund der antistatischen Aktivierung der Klebe- und/oder Siegelschicht durch Beimischung leitfähiger Partikel wird somit auf einfache Weise eine Verpackung geschaffen, die den verpackten Gegenstand wirkungsvoll und dauerhaft gegen eine elektrostatische Beschädigung schützt. Die Klebe- und/oder Siegelschicht ist dabei so beschaffen, dass nur in den Bereichen eine Klebe- oder Siegelwirkung auftritt, in denen zwei Oberflächen der Materialbahn aufeinanderliegen. Es findet somit also kein Verkleben der Materialbahn mit dem verpackten Gegenstand statt, Weist die Materialbahn einen mehrschichtigen Aufbau mit wenigstens einer gewellten Materialschicht auf, bietet die Verpackung zudem einen guten Schutz gegen eine mechanische Beschädigung des verpackten Körpers.

Um die erfindungsgemäße Verpackung noch zügiger herstellen zu können, erweist es sich als besonders vorteilhaft, wenn die Verpackung aus ausgeschnittenen oder ausgestanzten Abschnitten der Materialbahn gebildet ist. Die Abschnitte können dabei in Standardgrößen angeboten werden oder nach Rücksprache mit einem Verwender entsprechend vorkonfektioniert geliefert werden.

Die Klebe- und/oder Siegelschicht ist bevorzugt mit einer abziehbaren Schutzschicht belegt, die erst kurz vor dem Verpackungsvorgang von der entsprechenden Oberfläche abgezogen wird und die Klebe- und/oder Siegelschicht freigibt. Die abziehbare Schutzschicht verhindert somit zum einen ein ungewolltes Verkleben der Oberflächen, zum anderen verhindert sie eine Verschmutzung oder Beschädigung der Klebe- und/oder Siegelschicht. Um die erfindungsgemäße Verpackung auch in Umgebungen mit hoher Luftfeuchtigkeit einsetzen zu können, ist die Klebe- und/oder Siegelschicht bevorzugt zudem wasserabweisend aktiviert.

Weitere Vorteile, Merkmale und Besonderheiten der Erfindung ergeben sich aus der nachfolgenden Beschreibung bevorzugter, jedoch nicht beschränkender Ausführungsformen der Erfindung anhand der schematischen Zeichnungen. Es zeigt:

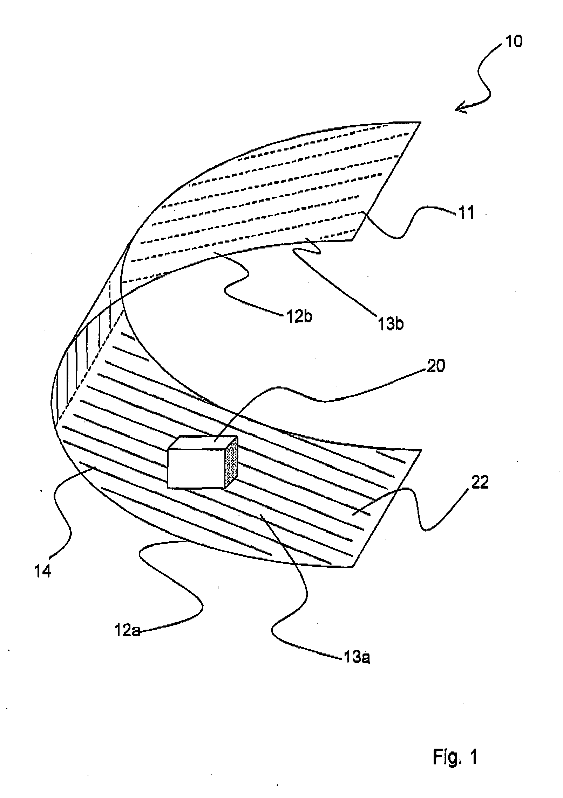

- Fig. 1: eine bevorzugte Ausführungsform einer einschichtigen Materialbahn, die zum Verpacken eines Gegenstandes eingesetzt wird,
- Fig, 2: eine bevorzugte Ausführungsform einer mehrschichtigen Materialbahn in perspektivischer Ansicht, und
- Fig, 3: eine aus einer Materialbahn gebildete Verpackung in Schnittdarstellung.

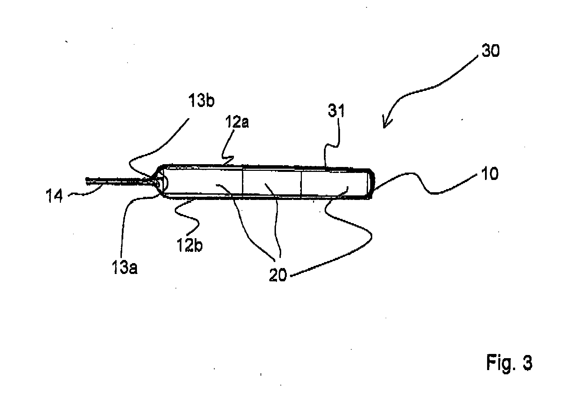

Fig. 1 zeigt einen Abschnitt 11 der erfindungsgemäßen Materialbahn 10, in den ein Gegenstand 20, insbesondere ein Elektronikbauteil verpackt wird. Der Abschnitt 11 wird hierbei etwa mittig umgefaltet (wie durch eine Strichlinie andeutet) und bildet quasi zwei Hälften 12 a, b, wobei der Gegenstand 20 auf die hier untere Hälfte 12a der Materialbahn 10 aufgelegt und die zweite Hälfte 12b der Materialbahn 10 über dem Gegenstand 20 umgeschlagen wird. Zur Fertigstellung der Verpackung 30 (vgl. Fig. 3) werden die dem Gegenstand 20 benachbarten Oberflächen 13a, b der ersten und zweiten Hälfte 12a, b des Abschnittes 11 der Materialbahn 10 aufeinandergelegt und die Flächen 22, die nicht mit dem Gegenstand 20 belegt sind, manuell zusammengedrückt bzw. maschinell druckbeaufschlagt. Die Materialbahn 10 weist hierzu an den dem Gegenstand zugewandten Oberflächen 13a, b eine Klebeschicht 14 auf, die aus mikroverkapseltem und bahnförmig aufgetragenem, drucksensitivem Klebstoff gebildet ist. Durch die Beimischung leitfähiger Pigmente ist der Klebstoff antistatisch aktiviert und weist daher eine hohe elektrische Leitfähigkeit auf.

Der zu verpackende Gegenstand 20, z. B. ein gegen elektrische Entladungen empfindliches Computerbauteil, wird somit effektiv geschützt. Aufgrund der Tatsache, dass die Verpackung 30 leitfähig ausgebildet ist, und dass sie zudem direkt am Gegenstand anliegt, entfällt eine zusätzliche Auffüllung von Zwischenräumen in der Verpackung 30 mit Füllmaterial, wie dies beispielsweise bei herkömmlichen Kartonverpackungen oftmals notwendig ist. Ebenfalls nicht notwendig ist das umständliche Aufrichten einer Kartonverpackung, da lediglich ein streifenförmiger Abschnitt 11 von einer in Rollenform vorgehaltenen Materialbahn 10 abgeschnitten oder abgerissen wird, um daraus die Verpackung 30 zu bilden.

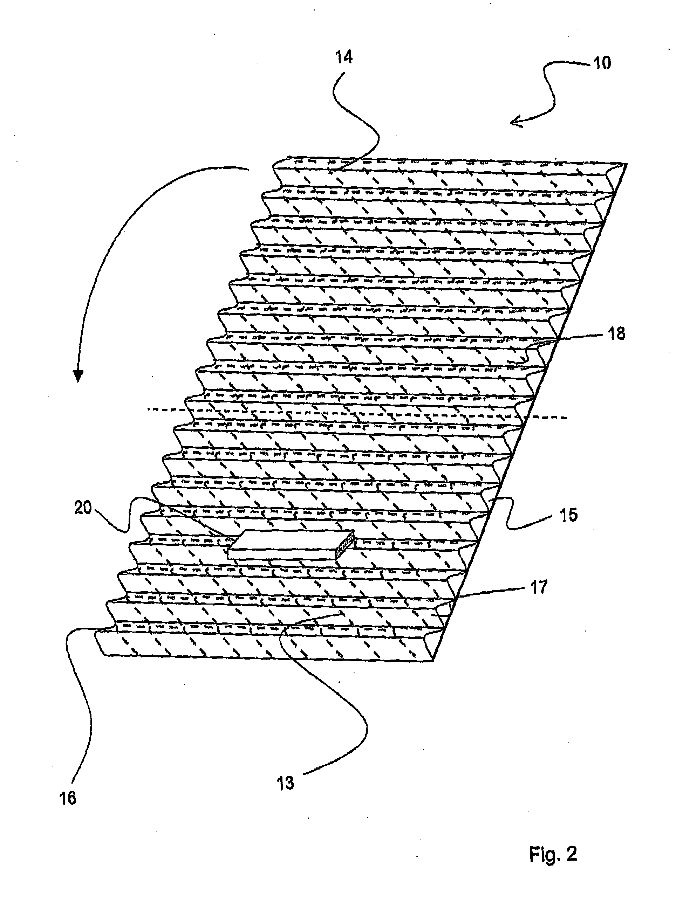

Fig. 2 zeigt eine weitere Ausführungsform der erfindungsgemäßen Materialbahn 10, wobei im Ausführungsbeispiel ein Zweischichtaufbau der Materialbahn 10 dargestellt ist. Auf einer ersten, ebenen Materialschicht 15 wurde hierbei eine zweite, gewellte Materialschicht 16 aufgeklebt. Die dem Gegenstand zugewandte Oberfläche 13 der gewellten Materialschicht 16 wurde zusätzlich mit einer drucksensitiven Klebeschicht 14 versehen. Zum Verpacken eines Gegenstandes 20 wird dieser im in Fig. 2 unteren Bereich 17 der Materialbahn 10 aufgelegt und der hier obere Bereich 18 der Materialbahn 10 um die strichlierte Mittelachse in Pfeilrichtung über den Gegenstand 20 eingeschlagen. Nach Druckbeaufschlagung der den Gegenstand 20 umgebenden Materialbahn 10 werden die aufeinanderliegenden Oberflächen 13a, b miteinander verklebt und somit eine Verpackung 30 nach Art eines Umschlages oder Tasche gebildet. Es ist auch denkbar, dass der Gegenstand 20 mittig auf der Materialbahn 10 aufgelegt wird und eine zweite, flächengleiche Materialbahn 10 auf die dargestellte Materialbahn 10 aufgebracht wird. Die zweite Materialbahn 10 weist dabei auf ihrer dem Gegenstand bzw. der ersten Materialbahn zugewandten Oberfläche 13 die erfindungsgemäße Klebeschicht 14 auf. Die aufeinanderliegenden Bereiche der Oberflächen 13a, b werden anschließend druckbeaufschlagt und die Verpackung 30 gebildet. Die Klebeschicht 14 ist dabei so ausgebildet, dass die Oberflächen 13a, b nur in Bereichen 17, 18 verkleben, in denen die beiden Klebeschichten 14 aufeinanderliegen. Es kommt somit nicht zu einem Verkleben der Materialbahn 10 mit dem zu verpackenden Gegenstand 20. Aufgrund der Ausgestaltung der Materialbahn 10 mit einer zusätzlichen gewellten Materialschicht 16, kann eine widerstandsfähige, stabile Verpackung 30 geschaffen werden.

Fig. 3 zeigt in Schnittdarstellung eine aus einer einschichtigen Materialbahn 10 (vgl. Fig. 1) geschaffene Verpackung 30 für einen Gegenstand 20, wobei auch mehrere derartiger Bauteile, insbesondere Elektronikkomponenten verpackt werden können. Die einschichtige Materialbahn 10 umhüllt hier z. B. drei solcher Gegenstände 20. An ihrer hier linken Seite (sowie an vor und hinter der Zeichenebene verlaufenden Kanten) liegen die mit der Klebeschicht 14 versehenen Oberflächen 13a, b der oberen und unteren Materialbahnhälfte 12a, b aufeinander, so dass die Verpackung 30 durch einfaches (manuelles oder maschinelles) Zusammendrücken verschlossen ist. Die durch Umfalten der Materialbahn 10 gebildete Verpackung 30 ist somit in Art einer Tasche geformt. Zusätzlich zur Beimischung von leitfähigen Partikeln zum Ausgangsmaterial der Klebeschicht 14 kann eine Beschichtung der äußeren Oberfläche 31 der Verpackung 30 mit Partikelmaterial, z. B. mit einem kohlenstoffhaltige Partikel enthaltenden Lack erfolgen. Denkbar ist darüber hinaus auch das Auftragen einer Schicht aus leitfähigen Metallpartikeln in einer geeigneten Trägersubstanz auf der äußeren Oberfläche 31 der Materialbahn 10.

### Bezugszeichenliste:

10 = Materialbahn
11 = Abschnitt
12a,b = Hälfte
13a,b = Oberfläche
14 = Klebeschicht (leitfähig)
15 = ebenen Materialschicht
16 = gewellte Materialschicht
17= unterer Bereich
18 = oberer Bereich
20 = Gegenstand
22 = Fläche
30 = Verpackung
31 = äußere Oberfläche

## Patentansprüche

1. Ein- oder mehrschichtige Materialbahn (10), insbesondere aus Zell- oder Faserstoff, wobei an wenigstens einer Oberfläche (13a, b) der Materialbahn (10) eine drucksensitive und/oder hitzeaktivierbare Klebe- und/oder Siegelschicht (14) vorgesehen ist,
**dadurch gekennzeichnet, dass**
die Klebe- und/oder Siegelschicht (14) leitfähig ausgebildet ist, insbesondere eine antistatische Beimischung oder leitfähige Pigmente aufweist.

2. Ein- oder mehrschichtige Materialbahn (10) nach Anspruch 1,
**dadurch gekennzeichnet, dass**
die Klebe- und/oder Siegelschicht (14) einen elektrischen Oberflächenwiderstand zwischen 10² und 10¹⁴ Ohm, insbesondere zwischen 10⁶ und 10¹² Ohm, bevorzugt zwischen 10⁸ und 10¹¹ Ohm aufweist.

3. Ein- oder mehrschichtige Materialbahn (10) nach Anspruch 1 oder 2,
**dadurch gekennzeichnet, dass**
die Beimischung aus einem kohlenstoffhaltigen und/oder metallhaltigen Partikelmaterial gebildet ist.

4. Ein- oder mehrschichtige Materialbahn (10) nach einem der vorhergehenden Ansprüche,
**dadurch gekennzeichnet, dass**
die Materialbahn (10) wenigstens eine gewellte Materialschicht (16) aufweist.

5. Ein- oder mehrschichtige Materialbahn (10) nach einem der vorhergehenden Ansprüche,
**dadurch gekennzeichnet, dass**
die Klebe- und/oder Siegelschicht (14) in die Materialschicht (15, 16) eingearbeitet ist.

6. Ein- oder mehrschichtige Materialbahn (10) nach einem der vorhergehenden Ansprüche,
**dadurch gekennzeichnet, dass**
die Klebe- und/oder Siegelschicht (14) punkt- und/oder bahnförmig auf der Materialbahn (10) aufgebracht ist.

7. Ein- oder mehrschichtige Materialbahn (10) nach einem der vorhergehenden Ansprüche,
**dadurch gekennzeichnet, dass**
die Klebe- und/oder Siegelschicht (14) mit einer abziehbaren Schutzschicht belegt ist,

8. Ein- oder mehrschichtige Materialbahn (10) nach einem der vorhergehenden Ansprüche,
**dadurch gekennzeichnet, dass**
die Klebe- und/oder Siegelschicht (14) wasserabweisende Eigenschaften aufweist.

9. Ein- oder mehrschichtige Materialbahn (10) nach einem der vorhergehenden Ansprüche,
**dadurch gekennzeichnet, dass**
die Klebe- und/oder Siegelschicht (14) staubbindend ausgebildet ist.

10. Verpackung (30) aus einer ein- oder mehrschichtigen Materialbahn (10) gemäß einem der vorangegangenen Ansprüche, insbesondere für einen gegenüber elektrischen Auföder Entladungen anfälligen Gegenstand (20),
**dadurch gekennzeichnet, dass**
die Verpackung (30) nach Art einer Umhüllung, insbesondere in Taschen- oder Umschlagform, ausgebildet ist, wobei die Umhüllung durch Aufeinanderlegen von mit der drucksensitiven und/oder hitzeaktivierbaren Klebe- und/oder Siegelschicht (14) versehenen Oberflächen (13a, b) und/oder Oberflächenabschnitten der Materialbahn (10) gebildet ist.

11. Verpackung (30) nach Anspruch 10,
**dadurch gekennzeichnet, dass**
die Verpackung (30) aus ausgeschnittenen oder ausgestanzten Abschnitten (11) der Materialbahn (10) gebildet ist.

12. Verpackung (30) nach Anspruch 10 oder 11
**dadurch gekennzeichnet, dass**
die Klebe- und/oder Siegelschicht (14) mit einer abziehbaren Schutzschicht belegt ist.

13. Verpackung (30) nach einem der Ansprüche 10 bis 12,
**dadurch gekennzeichnet, dass**
die Klebe- und/oder Siegelschicht (14) wasserabweisend aktiviert ist.
